(19) Europäisches Patentamt
European Patent Office
Office européen des brevets

(11) **EP 4 723 827 A1**

(12) **EUROPEAN PATENT APPLICATION**
published in accordance with Art. 153(4) EPC

(43) Date of publication:
08.04.2026 Bulletin 2026/15

(21) Application number: 24814617.7

(22) Date of filing: 31.05.2024

(51) International Patent Classification (IPC):
$H10D\ 18/00^{(2025.01)}$    $H10D\ 18/60^{(2025.01)}$
$H10D\ 62/10^{(2025.01)}$    $H10D\ 62/17^{(2025.01)}$
$H10D\ 18/01^{(2025.01)}$

(86) International application number:
PCT/CN2024/096808

(87) International publication number:
WO 2024/245423 (05.12.2024 Gazette 2024/49)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 02.06.2023 CN 202310645829

(71) Applicant: Tsinghua University
Beijing 100084 (CN)

(72) Inventors:
• LIU, Jiapeng
Beijing 100084 (CN)

• WU, Jinpeng
Beijing 100084 (CN)
• ZENG, Rong
Beijing 100084 (CN)
• ZHANG, Junming
Beijing 100084 (CN)
• YU, Zhanqing
Beijing 100084 (CN)
• QU, Lu
Beijing 100084 (CN)
• CHEN, Zhengyu
Beijing 100084 (CN)

(74) Representative: Boult Wade Tennant LLP
Salisbury Square House
8 Salisbury Square
London EC4Y 8AP (GB)

(54) **GATE-COMMUTATED THYRISTOR AND PREPARATION METHOD THEREFOR**

(57) The present disclosure provides a gate-commutated thyristor and a preparation method therefor. The gate-commutated thyristor comprises: a first conductivity type base region; a second conductivity type base region provided on the first conductivity type base region; the second conductivity type base region comprising a second conductivity type third base region provided on the first conductivity type base region, a second conductivity type second base region provided on the second conductivity type third base region, and a second conductivity type first base region provided on the second conductivity type second base region; a first conductivity type emitter having a boss structure and covering a part of an upper surface of the second conductivity type first base region; and second conductivity type doped regions located on both sides of the second conductivity type first base region and the second conductivity type second base region. According to the present disclosure, the current turn-off capability of the gate-commutated thyristor can be improved.

FIG. 1

Description

## TECHNICAL FIELD

. The present disclosure relates to the technical field of semiconductor devices, and in particular, to a gate-commutated thyristor and a preparation method therefor.

## BACKGROUND

. The gate-commutated thyristor (GCT) is a current-controlled fully controlled power electronic device, has features such as low on-state voltage drop, strong surge capability and large power capacity, is typically used in a large-capacity power electronic apparatus, such as a power grid converter apparatus, a marine electric power system, and a direct-current power grid solid-state circuit breaker. In direct-current circuit breaker application, a capability of a device to turn off the current will directly determine a circuit topology design and apparatus cost. A GCT chip with a good turn-off capability may simplify circuit topology, reduce cost and improve apparatus reliability.

Longitudinal structure of existing commercial GCT chips mainly contains PNPN four layers. When being conducted, a cathode and an anode simultaneously inject electrons and holes into a base region, which reduces on-state voltage drop. Turn-off is achieved by driving a reverse voltage applied to a gate cathode via a gate, forcibly diverting a cathode current to flow out through the gate, changing a GCT conductive channel to be a triode structure, decreasing the current and rising the voltage in a transient process to obtain finally turn-off.

Capability of the GCT to turn off the current is mainly restricted by two aspects. One aspect is hard turn-off capability determined by a drive reverse voltage and a gate cathode loop stray impedance. The other aspect is turn-off capability with a hard condition being satisfied, which is determined by the longitudinal structure of the device. The latter is determined by the longitudinal doped structure of the device, especially the second conductivity type base region, which is currently a weak point of the turn-off capability.

The second conductivity type base region provides a low-resistance current channel, at the same time, may share the voltage during the voltage rise phase of the turn-off transient. However, in prior arts, the transverse resistance of the second conductivity type base region and the gate cathode junction reverse breakdown voltage have a mutually restrictive relationship. In addition, during the voltage rise phase, its internal electric field cannot be expanded sufficiently, which may lead to the occurrence of severe dynamic avalanche. These restrict the capability of the device to turn off the current.

## SUMMARY

Main purpose of the embodiments of the present disclosure is to provide a gate-commutated thyristor and a preparation method therefor, so as to improve the capability of the gate-commutated thyristor to turn off the current.

To achieve said purpose, the embodiments of the present disclosure provide a gate-commutated thyristor, comprising:

a first conductivity type base region;
a second conductivity type base region provided on the first conductivity type base region; the second conductivity type base region comprising a second conductivity type third base region provided on the first conductivity type base region, a second conductivity type second base region provided on the second conductivity type third base region, and a second conductivity type first base region provided on the second conductivity type second base region;
a first conductivity type emitter having a boss structure and covering a part of an upper surface of the second conductivity type first base region; and
second conductivity type doped regions located on both sides of the second conductivity type first base region and the second conductivity type second base region.

In one of the embodiments, the gate-commutated thyristor further comprises:
gate electrodes provided on the second conductivity type first base region, the gate electrodes being located on both sides of the first conductivity type emitter and being in contact with the second conductivity type doped regions located in the second conductivity type first base region.

In one of the embodiments, the gate-commutated thyristor further comprises:
a cathode electrode provided on the first conductivity type emitter.

In one of the embodiments, a doping concentration of the second conductivity type doped regions is greater than or equal to a doping concentration of the second conductivity type second base region, the doping concentration of the second conductivity type second base region is greater than a doping concentration of the second conductivity type third base region, the doping concentration of the second conductivity type third base region is greater than or equal to a doping concentration of the second conductivity type first base region, and the doping concentration of the second conductivity type third base region is determined by a target turn-off current density and a carrier saturation drift rate.

In one of the embodiments, a top portion of the first conductivity type base region has a protrusion corresponding to the first conductivity type emitter.

In one of the embodiments, the gate-commutated thyristor further comprises:

a second conductivity type emitter, on which the first conductivity type base region is provided.

In one of the embodiments, the gate-commutated thyristor further comprises:

an anode electrode, on which the second conductivity type emitter is provided.

In one of the embodiments, the gate-commutated thyristor further comprises:

a first conductivity type buffer layer located between the second conductivity type emitter and the first conductivity type base region.

The gate-commutated thyristor in the embodiments of the present disclosure comprises the first conductivity type base region; the second conductivity type base region provided on the first conductivity type base region; the first conductivity type emitter having a boss structure and covering a part of an upper surface of the second conductivity type first base region; and second conductivity type doped regions located on both sides of the second conductivity type first base region and the second conductivity type second base region, and the capability of the gate-commutated thyristor to turn off the current may be improved.

Embodiments of the present disclosure further provide a method for preparing the gate-commutated thyristor as described above, comprising:

providing a first conductivity type substrate;
epitaxially forming a second conductivity type third base region on the first conductivity type substrate;
epitaxially forming a second conductivity type second base region on the second conductivity type third base region;
epitaxially forming a second conductivity type first base region on the second conductivity type second base region;
performing a corrosion process to form a boss structure after injecting first conductivity type ions into an upper surface of the second conductivity type first base region;
selectively injecting second conductivity type ions into a surface of the second conductivity type first base region;
performing a high-temperature diffusion process on the first conductivity type ions and the second conductivity type ions to form a first conductivity type emitter and second conductivity type doped regions, respectively.

In one of the embodiments, the method further comprises:

injecting second conductivity type ions into a lower surface of the first conductivity type substrate;
performing high-temperature annealing treatment on the first conductivity type substrate after being injected with the second conductivity type ions to form a second conductivity type emitter, and a first conductivity type base region provided on the second conductivity type emitter.

In one of the embodiments, the method further comprises:

injecting first conductivity type ions into a lower surface of the first conductivity type substrate;
performing high-temperature annealing treatment on the first conductivity type substrate after being injected with the first conductivity type ions to form a first conductivity type buffer layer, and a first conductivity type base region provided on the first conductivity type buffer layer;
injecting second conductivity type ions into a lower surface of the first conductivity type buffer layer to form a second conductivity type emitter.

In one of the embodiments, the method further comprises:

forming an anode electrode under the second conductivity type emitter;
forming a cathode electrode on the first conductivity type emitter;
forming gate electrodes at positions on both sides of the first conductivity type emitter and in contact with the second conductivity type doped regions located in the second conductivity type first base region.

The method for preparing the gate-commutated thyristor in the embodiments of the present disclosure may form an asymmetric GCT structure and a reverse-blocking GCT structure, and improve the capability of the device to turn off the current.

**BRIEF DESCRIPTION OF DRAWINGS**

In order to describe the technical solutions in the embodiments of the present disclosure or the prior arts more clearly, the drawings required for the embodiments are briefly introduced below. Obviously, the drawings in the following description are only some embodiments of the present disclosure. Those skilled in the art may further obtain other drawings based on these drawings under the premise that they do not pay inventive labor.

FIG. 1 is a schematic diagram of a reverse-blocking gate-commutated thyristor in an embodiment of the present disclosure;
FIG. 2 is a schematic diagram of a reverse-blocking gate-commutated thyristor in another embodiment of the present disclosure;
FIG. 3 is a schematic diagram of an asymmetric gate-commutated thyristor in an embodiment of the present disclosure;
FIG. 4 is a schematic diagram of an asymmetric gate-commutated thyristor in another embodiment of the present disclosure;

FIG. 5 is a schematic diagram of comparing a doping concentration curve in the (2) direction in FIG. 1 in the embodiments of the present disclosure with a doping concentration curve in the same direction in the prior arts;

FIG. 6 is a flow diagram of a method for preparing a gate-commutated thyristor in the embodiments of the present disclosure;

FIG. 7 is a flow diagram of forming an emitter and a first conductivity type base region in an embodiment of the present disclosure;

FIG. 8 is a flow diagram of forming an emitter and a first conductivity type base region in another embodiment of the present disclosure;

FIG. 9 is a flow diagram of forming electrodes in the embodiments of the present disclosure.

## DESCRIPTION OF EMBODIMENTS

The technical solutions in the embodiments of the present disclosure will be described clearly and completely with reference to the drawings in the embodiments of the present disclosure. Obviously, the described embodiments are only some embodiments of the present disclosure, rather than all embodiments. Based on the embodiments in the present disclosure, all other embodiments obtained by those skilled in the art without paying inventive labor fall into the scope protected by the present disclosure.

Those skilled in the art know that embodiments of the present application may be implemented as a system, an apparatus, an equipment, a method or a computer program product. Therefore, the present disclosure may be specifically implemented in the following forms, i.e., complete hardware, complete software (including firmware, resident software, microcode, etc.), or a combination of hardware and software.

Given that prior arts restrict the capability of the device to turn off the current, the embodiments of the present disclosure provide a gate-commutated thyristor and a preparation method therefor, which are applicable to a GCT part of an asymmetric IGCT device, a reverse-blocking IGCT device and a reverse-conducting IGCT device, and can improve the capability of the gate-commutated thyristor to turn off the current. A detailed description of the present disclosure is made below in combination with the drawings.

The first conductivity type in the present disclosure is n-type doping, and the second conductivity type is p-type doping. Alternatively, an opposite doping relationship may also be adopted, the second conductivity type is n-type doping and the first conductivity type is p-type doping. In this case, corresponding positions of cathode and anode electrodes are also swapped.

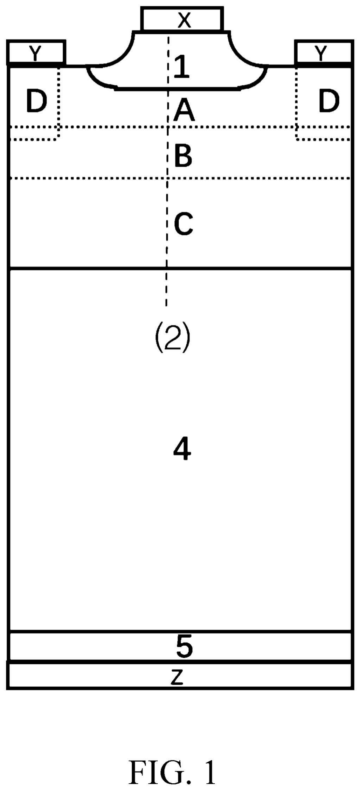

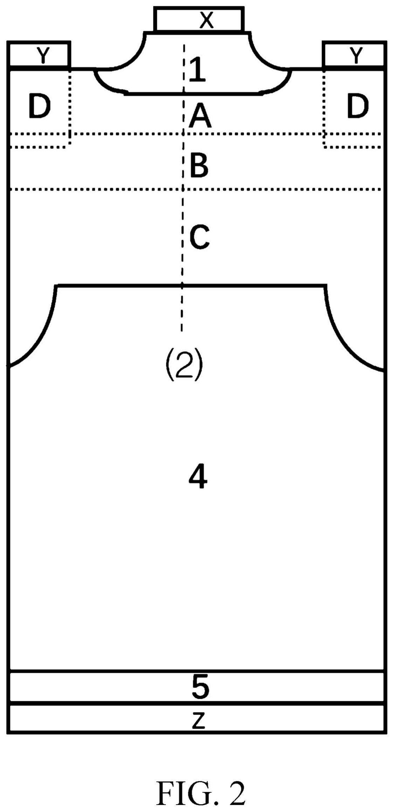

FIG. 1 is a schematic diagram of a reverse-blocking gate-commutated thyristor in an embodiment of the present disclosure. FIG. 2 is a schematic diagram of a reverse-blocking gate-commutated thyristor in another embodiment of the present disclosure. J2 junction in the reverse-blocking gate-commutated thyristor in FIG. 1 has a planar feature, J2 junction in the reverse-blocking gate-commutated thyristor in FIG. 2 has a non-planar feature, and a top portion of the first conductivity type base region 4 has a protrusion corresponding to the first conductivity type emitter 1. As shown in FIG. 1 and FIG. 2, the gate-commutated thyristor in the embodiments of the present disclosure comprises:

a first conductivity type base region 4;
a second conductivity type base region provided on the first conductivity type base region 4, which is uniformly doped at a constant concentration; the second conductivity type base region comprising a second conductivity type third base region C provided on the first conductivity type base region, a second conductivity type second base region B provided on the second conductivity type third base region C, and a second conductivity type first base region A provided on the second conductivity type second base region B;
a first conductivity type emitter 1 having a boss structure and covering a part of an upper surface of the second conductivity type first base region A; and
second conductivity type doped regions D located on both sides of the second conductivity type first base region A and the second conductivity type second base region B,
wherein a doping concentration of the second conductivity type doped regions D is greater than or equal to a doping concentration of the second conductivity type second base region B, the doping concentration of the second conductivity type second base region B is greater than a doping concentration of the second conductivity type third base region C, the doping concentration of the second conductivity type third base region C is greater than or equal to a doping concentration of the second conductivity type first base region A, and the doping concentration of the second conductivity type third base region C is determined by a target turn-off current density and a carrier saturation drift rate. A thickness of the second conductivity type third base region C is greater than a thickness of the second conductivity type first base region A and is also greater than a thickness of the second conductivity type second base region B.

The doping concentration of the second conductivity type first base region A does not exceed 5E15 according to a requirement (200V) of a gate cathode breakdown voltage; for example, the concentration is in the range of 5E13 cm$^{-3}$ to 5E15cm$^{-3}$, and the thickness is in the range of 10 um to 30 um.

The doping concentration of the second conductivity type second base region B does not exceed 1E18 to ensure normal switch-on of the device; for example, the concentration is in the range of 5E16 cm$^{-3}$ to 1E18 cm$^{-3}$, and the thickness is in the range of 10 um to 30 um.

A doping concentration range of the second conductivity type second base region C is as follows:

$$0.8 \frac{j}{qv_{sat}} < N_{A/D} < 1.2 \frac{j}{qv_{sat}} ;$$

where j denotes a target turn-off current density, q denotes an elementary electric charge (1.6E-19 Coulombs), $v_{sat}$ denotes a hole/electron saturation drift rate at a certain temperature (a hole saturation drift rate when the first conductivity type is n-type, an electron saturation drift rate when the first conductivity type is p-type), and $N_{A/D}$ denotes the doping concentration of the second conductivity type second base region C.

According to different target turn-off current densities, the concentration range of the second conductivity type third base region C is between 5E13 and 5E15 cm$^{-3}$; the thickness is within the range of 40 um to 80 um.

In an embodiment, the second conductivity type doped regions D are high-concentration doped regions, providing local high-concentration doping regions D at positions where the surface of the second conductivity type first base region A is in contact with the gate electrodes Y may form a reliable and good metal-semiconductor ohmic contact, and at the same time they are connected with the second base region to form a low-resistance current channel. A surface concentration of the second conductivity type doped regions D is in the range of 1E18 cm$^{-3}$ to 5E18 cm$^{-3}$, and has a local Gaussian distribution at gate contact positions, the concentration is in the range of 1E17 cm$^{-3}$ to 5E17 cm$^{-3}$ when reaching the second conductivity type base region.

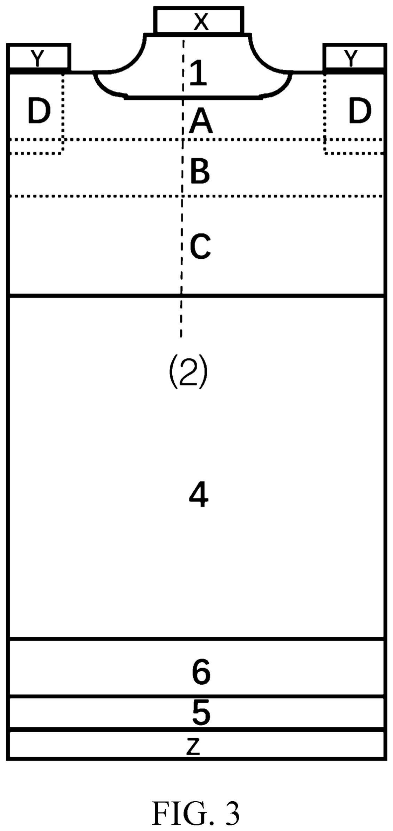

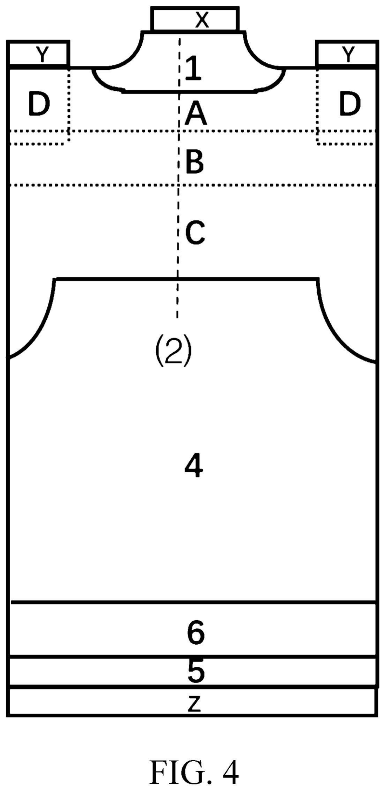

FIG. 3 is a schematic diagram of an asymmetric gate-commutated thyristor in an embodiment of the present disclosure. FIG. 4 is a schematic diagram of an asymmetric gate-commutated thyristor in another embodiment of the present disclosure. J2 junction in the asymmetric gate-commutated thyristor in FIG. 3 has a planar feature, J2 junction in the asymmetric gate-commutated thyristor in FIG. 4 has a non-planar feature, and a top portion of the first conductivity type base region 4 has a protrusion corresponding to the first conductivity type emitter 1. As shown in FIG. 3 and FIG. 4, the gate-commutated thyristor further comprises:

gate electrodes Y provided on the second conductivity type first base region A, the gate electrodes Y being located on both sides of the first conductivity type emitter 1 and being in contact with the second conductivity type doped regions D located in the second conductivity type first base region A;
a cathode electrode X provided on the first conductivity type emitter;
a second conductivity type emitter 5, on which the first conductivity type base region 4 is provided;
an anode electrode z, on which the second conductivity type emitter 5 is provided; and
a first conductivity type buffer layer 6 located between the second conductivity type emitter 5 and the first conductivity type base region 4.

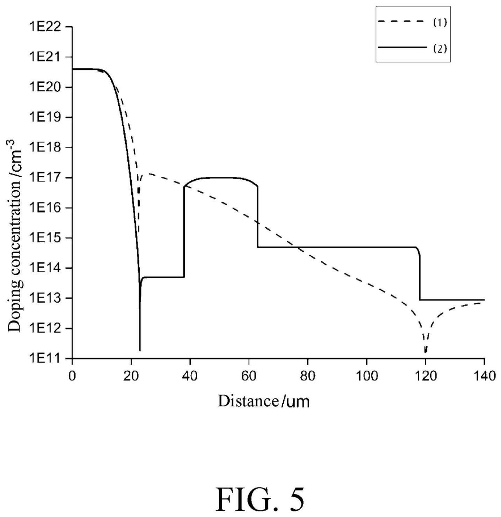

FIG. 5 is a schematic diagram of comparing a doping concentration curve in the (2) direction in FIG. 1 in the embodiments of the present disclosure with a doping concentration curve in the same direction in the prior arts. As shown in FIG. 5, a second conductivity type base region doping curve in the prior arts may be divided into two parts, i.e., a high-concentration base region and a low-concentration base region, according to the doping concentration. This doping is formed by high-temperature diffusion after injection /deposition of boron and aluminum ions, and the doping curve approximately satisfies the Gaussian function. This kind of structure has deficiencies in two aspects for improving the turn-off capability: firstly, a higher gate cathode blocking voltage and a smaller lateral resistance of current path from beneath the cathode to the gate are both beneficial for improving the turn-off capability of the device. However, the former requires a lower doping concentration, while the latter requires a higher doping concentration, a single high-concentration base region cannot satisfy these two requirements simultaneously; secondly, the low-concentration base region with Gaussian distribution has a larger concentration gradient, which prevents an electric field from being sufficiently expanded during the turn-off process, and a peak field intensity is larger, which is prone to cause a severe dynamic avalanche effect and limits the capability of the device to turn off the current.

The structure of three-layer base region being of second conductivity type in the present disclosure may simultaneously increase the gate cathode blocking voltage of the device, reduce the lateral resistance of current path from beneath the cathode to the gate) and decrease a bulk electric field intensity when turning off a large current, thereby improving the capability of the device to turn off the current.

To sum up, the gate-commutated thyristor provided in the embodiments of the present disclosure has the following advantageous:

(1) The second conductivity type first base region increases the reverse breakdown voltage of the gate cathode junction, thereby allowing the driver to apply a higher reverse voltage between the gate and the cathode during the turn-off transient. The preferred embodiment can achieve a gate cathode reverse voltage of more than 200 V., which is improved by an order of magnitude compared with the current commercial GCT.

(2) In addition, the second conductivity type second base region provides a low-resistance current channel, reduces the lateral voltage drop within the base regions during the turn-off transient, and switch-on performance and turn-on performance of the device are rarely affected.

(3) It attenuates the dynamic avalanche effect during the voltage rise phase of the turn-off transient when the target turn-off current density is relatively high. Compared with a Gaussian distribution structure formed by diffusion in a traditional way, the second conductivity type third base region adopts uniform concentration doping. After optimization of the concentration value, the internal electric field gradient can be reduced to a level close to zero when a certain target turn-off current density is turned off, thereby reducing the peak field strength.

(4) The capability of the device to turn off the current in case of satisfying hard conditions, i.e., the turn-off current limited by the emitter self-triggering is improved.

Based on the same application concept, the embodiments of the present disclosure further provide a method for preparing the gate-commutated thyristor. Since the principle of solving a problem by the method is similar to that of the gate-commutated thyristor, for implementation of the method, implementation of the gate-commutated thyristor may be referred to, repetitive contents are not elaborated here.

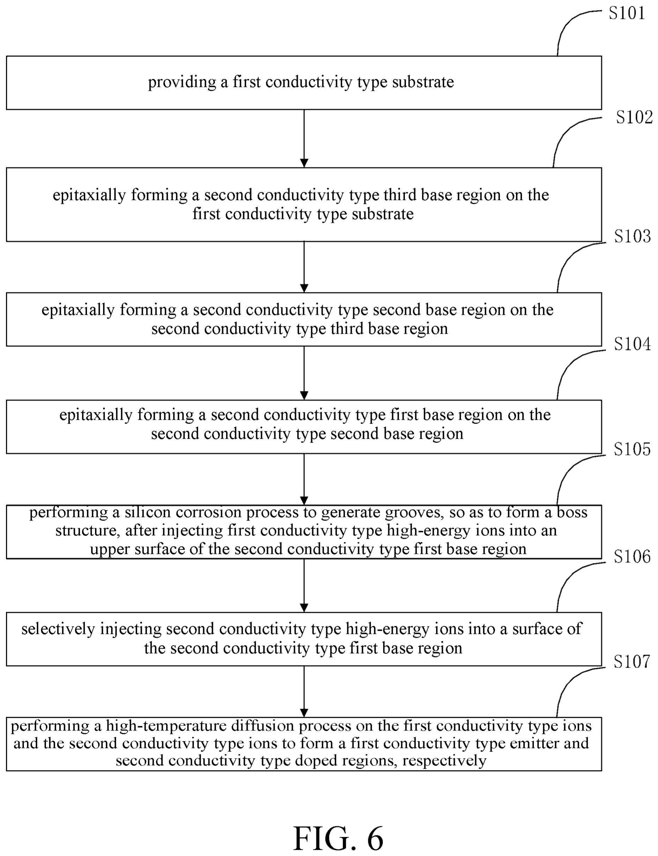

FIG. 6 is a flow diagram of a method for preparing the gate-commutated thyristor in the embodiments of the present disclosure. As shown in FIG. 6, the method for preparing the gate-commutated thyristor comprises:

S101: providing a first conductivity type substrate.

S102: epitaxially forming a second conductivity type third base region on the first conductivity type substrate.

S103: epitaxially forming a second conductivity type second base region on the second conductivity type third base region.

S104: epitaxially forming a second conductivity type first base region on the second conductivity type second base region.

S105: performing a silicon corrosion process to generate grooves, so as to form a boss structure after injecting first conductivity type high-energy ions into an upper surface of the second conductivity type first base region.

S106: selectively injecting second conductivity type high-energy ions into a surface of the second conductivity type first base region.

S107: performing a high-temperature diffusion process on the first conductivity type ions and the second conductivity type ions to form a first conductivity type emitter and second conductivity type doped regions, respectively.

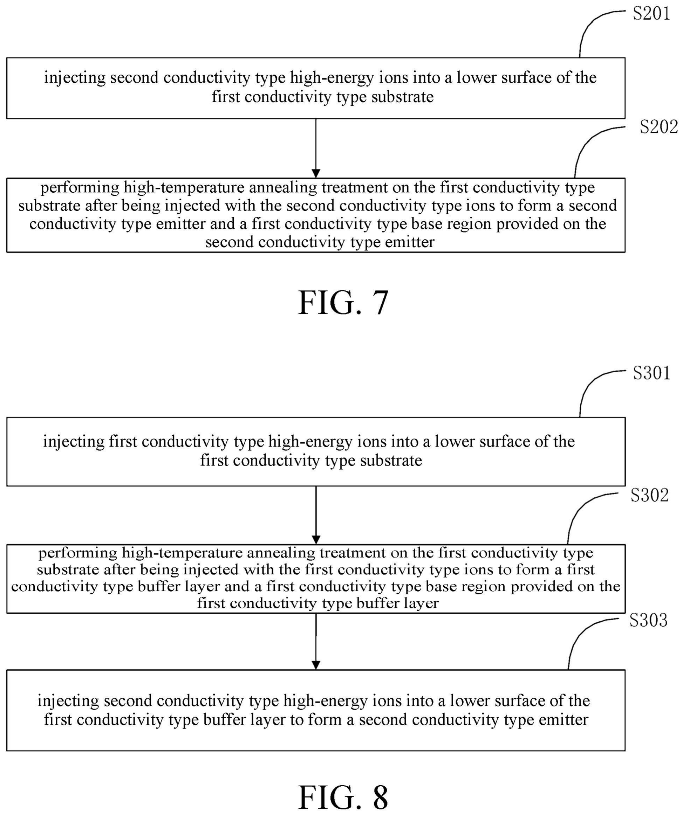

FIG. 7 is a flow diagram of forming an emitter and a first conductivity type base region in an embodiment of the present disclosure. As shown in FIG. 7, after executing S107, the method further comprises:

S201: injecting second conductivity type high-energy ions into a lower surface of the first conductivity type substrate.

S202: performing high-temperature annealing treatment on the first conductivity type substrate after being injected with the second conductivity type ions to form a second conductivity type emitter, and a first conductivity type base region provided on the second conductivity type emitter.

FIG. 8 is a flow diagram of forming an emitter and a first conductivity type base region in another embodiment of the present disclosure. As shown in FIG. 8, after executing S107, the method further comprises:

S301: injecting first conductivity type high-energy ions into a lower surface of the first conductivity type substrate.

S302: performing high-temperature annealing treatment on the first conductivity type substrate after being injected with the first conductivity type ions to form a first conductivity type buffer layer, and a first conductivity type base region provided on the first conductivity type buffer layer.

S303: injecting second conductivity type high-energy ions into a lower surface of the first conductivity type buffer layer to form a second conductivity type emitter.

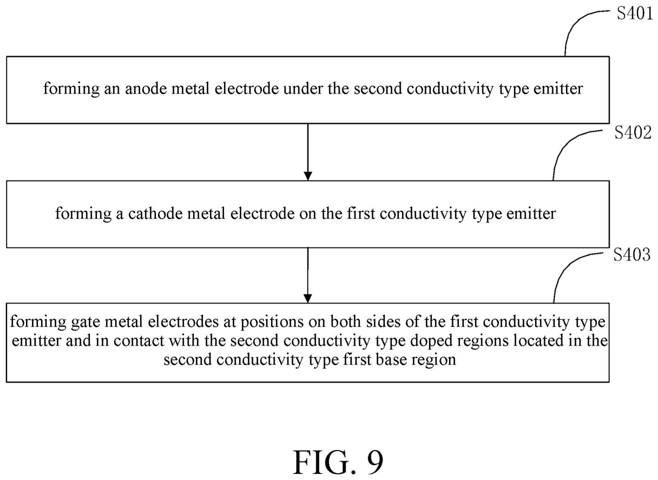

FIG. 9 is a flow diagram of forming electrodes in an embodiment of the present disclosure. As shown in FIG. 9, after executing S202 or S303, the method further comprises:

S401: forming an anode metal electrode under the second conductivity type emitter.

S402: forming a cathode metal electrode on the first conductivity type emitter.

S403: forming gate metal electrodes at positions on both sides of the first conductivity type emitter and in contact with the second conductivity type doped regions located in the second conductivity type first base region (i.e., above the gate contact structure of the second conductivity type first base region).

To sum up, the method for preparing the gate-commutated thyristor in the embodiments of the present disclosure may form an asymmetric GCT structure and a reverse-blocking GCT structure, further improving the capability of the device to turn off the current.

The above embodiments further elaborate the purpose, the technical solution and the advantageous effect of the present disclosure. It should be understood that the above contents are only specific embodiments of the present disclosure and are not used to limit the protection scope of the present disclosure, and any modification, equivalent replacement, improvement, etc. made within the spirit and principle of the present disclosure shall be included in the protection scope of the present disclosure.

Those skilled in the art may further understand that various illustrative logical blocks, units, and steps listed in the embodiments of the present disclosure may be implemented through electronic hardware, computer software, or a combination thereof. To clearly demonstrate interchangeability of hardware and software, for the above-mentioned various illustrative components, units and steps, their functions have been generally described. Implementing such functions via hardware or software depends on specific application and design requirements of an entire system. Those skilled in the art may use various methods to implement said functions for each specific application, but such implementation should not be understood as exceeding the protection scope of the embodiments of the present disclosure.

Various illustrative logic blocks, or units, or devices described in the embodiments of the present disclosure may implement or operate the described functions via a design of a general-purpose processor, a digital signal processor, an application-specific integrated circuit (ASIC), a field-programmable gate array or other programmable logic device, a discrete gate or transistor logic, a discrete hardware component, or any combination of the above. The general-purpose processor may be a microprocessor. Optionally, the general-purpose processor may also be any traditional processor, controller, microcontroller or state machine. Processor may further be implemented via a combination of computing devices, such as a digital signal processor and a microprocessor, multiple microprocessors, one or more microprocessors combined with one digital signal processor core, or any other similar configuration.

Steps of the method or algorithm described in the embodiments of the present disclosure may be directly embedded in hardware, a software module executed by a processor, or a combination thereof. A software module may be stored in a RAM memory, a flash memory, a ROM memory, an EPROM memory, an EEPROM memory, a register, a hard disk, a mobile magnetic disk, a CD-ROM or any other form of storage medium in this field. Exemplarily, the storage medium may be connected to a processor, so that the processor may read information from the storage medium and write information to the storage medium. Optionally, the storage medium may further be integrated into a processor. The processor and the storage medium may be set in an ASIC, and the ASIC may be set in a user terminal.

Optionally, the processor and the storage medium may further be set in different components of the user terminal.

In one or more exemplary designs, the above-mentioned functions described in the embodiments of the present disclosure may be implemented in hardware, software, firmware, or any combination thereof. If implemented in software, these functions may be stored on a computer-readable medium, or transmitted to a computer-readable medium in the form of one or more instructions or codes. Computer-readable medium includes a computer storage medium and a communication medium that facilitates the transfer of a computer program from one place to another. The storage medium may be any available media that may be accessed by any general-purpose or special computer. For example, such computer-readable media may include but not be limited to RAM, ROM, EEPROM, CD-ROM or other optical disc storage, disk storage or other magnetic storage device, or any other medium that may be used to carry or store program codes in the form of instructions or data structures and other forms that can be read by general-purpose or special computers or general-purpose or special processors. In addition, any connection may be appropriately defined as a computer-readable medium. For example, if software is transmitted from a website site, server or other remote resource via a coaxial cable, optical fiber cable, twisted-pair wire, digital subscriber line (DSL), or in a wireless manner such as infrared, wireless and microwave, it is also included in the defined computer-readable medium. The disks and the discs include compressed disks, laser disks, optical discs, DVDs, floppy disks and blue-ray disc. Discs usually replicate data magnetically, while disks usually replicate data optically by laser. A combination thereof may also be included in a computer-readable medium.

**Claims**

1. A gate-commutated thyristor, **characterized by** comprising:

   a first conductivity type base region;
   a second conductivity type base region provided on the first conductivity type base region; the second conductivity type base region comprising a second conductivity type third base region provided on the first conductivity type base region, a second conductivity type second base region provided on the second conductivity type third base region, and a second conductivity type first base region provided on the second conductivity type second base region;
   a first conductivity type emitter having a boss structure and covering a part of an upper surface of the second conductivity type first base region; and

second conductivity type doped regions located on both sides of the second conductivity type first base region and the second conductivity type second base region;

wherein a doping concentration of the second conductivity type doped regions is greater than or equal to a doping concentration of the second conductivity type second base region, the doping concentration of the second conductivity type second base region is greater than a doping concentration of the second conductivity type third base region, the doping concentration of the second conductivity type third base region is greater than or equal to a doping concentration of the second conductivity type first base region, and the doping concentration of the second conductivity type third base region is determined by a target turn-off current density and a carrier saturation drift rate.

2. The gate-commutated thyristor according to claim 1, **characterized by** further comprising:
gate electrodes provided on the second conductivity type first base region, the gate electrodes being located on both sides of the first conductivity type emitter and being in contact with the second conductivity type doped regions located in the second conductivity type first base region.

3. The gate-commutated thyristor according to claim 1, **characterized by** further comprising:
a cathode electrode provided on the first conductivity type emitter.

4. The gate-commutated thyristor according to claim 1, **characterized in that** a top portion of the first conductivity type base region has a protrusion corresponding to the first conductivity type emitter.

5. The gate-commutated thyristor according to claim 1, **characterized by** further comprising:
a second conductivity type emitter, on which the first conductivity type base region is provided.

6. The gate-commutated thyristor according to claim 5, **characterized by** further comprising:
an anode electrode, on which the second conductivity type emitter is provided.

7. The gate-commutated thyristor according to claim 5, **characterized by** further comprising:
a first conductivity type buffer layer located between the second conductivity type emitter and the first conductivity type base region.

8. A method for preparing the gate-commutated thyristor according to any one of claims 1 to 7, **characterized by** comprising:

providing a first conductivity type substrate;
epitaxially forming a second conductivity type third base region on the first conductivity type substrate;
epitaxially forming a second conductivity type second base region on the second conductivity type third base region;
epitaxially forming a second conductivity type first base region on the second conductivity type second base region;
performing a corrosion process to form a boss structure after injecting first conductivity type ions into an upper surface of the second conductivity type first base region;
selectively injecting second conductivity type ions into a surface of the second conductivity type first base region; and
performing a high-temperature diffusion process on the first conductivity type ions and the second conductivity type ions to form a first conductivity type emitter and second conductivity type doped regions, respectively.

9. The method for preparing the gate-commutated thyristor according to claim 8, **characterized by** further comprising:

injecting second conductivity type ions into a lower surface of the first conductivity type substrate; and
performing high-temperature annealing treatment on the first conductivity type substrate after being injected with the second conductivity type ions to form a second conductivity type emitter, and a first conductivity type base region provided on the second conductivity type emitter.

10. The method for preparing the gate-commutated thyristor according to claim 8, **characterized by** further comprising:

injecting first conductivity type ions into a lower surface of the first conductivity type substrate;
performing high-temperature annealing treatment on the first conductivity type substrate after being injected with the first conductivity type ions to form a first conductivity type buffer layer, and a first conductivity type base region provided on the first conductivity type buffer layer; and
injecting second conductivity type ions into a lower surface of the first conductivity type buffer layer to form a second conductivity type emitter.

11. The method for preparing the gate-commutated thyristor according to claim 9 or 10, **characterized by** further comprising:

forming an anode electrode under the second conductivity type emitter;

forming a cathode electrode on the first conductivity type emitter; and

forming gate electrodes at positions on both sides of the first conductivity type emitter and in contact with the second conductivity type doped regions located in the second conductivity type first base region.

FIG. 1

FIG. 2

FIG. 3

FIG. 4

FIG. 5

S101

providing a first conductivity type substrate

S102

epitaxially forming a second conductivity type third base region on the first conductivity type substrate

S103

epitaxially forming a second conductivity type second base region on the second conductivity type third base region

S104

epitaxially forming a second conductivity type first base region on the second conductivity type second base region

S105

performing a silicon corrosion process to generate grooves, so as to form a boss structure, after injecting first conductivity type high-energy ions into an upper surface of the second conductivity type first base region

S106

selectively injecting second conductivity type high-energy ions into a surface of the second conductivity type first base region

S107

performing a high-temperature diffusion process on the first conductivity type ions and the second conductivity type ions to form a first conductivity type emitter and second conductivity type doped regions, respectively

FIG. 6

S201

injecting second conductivity type high-energy ions into a lower surface of the first conductivity type substrate

S202

performing high-temperature annealing treatment on the first conductivity type substrate after being injected with the second conductivity type ions to form a second conductivity type emitter and a first conductivity type base region provided on the second conductivity type emitter

FIG. 7

S301

injecting first conductivity type high-energy ions into a lower surface of the first conductivity type substrate

S302

performing high-temperature annealing treatment on the first conductivity type substrate after being injected with the first conductivity type ions to form a first conductivity type buffer layer and a first conductivity type base region provided on the first conductivity type buffer layer

S303

injecting second conductivity type high-energy ions into a lower surface of the first conductivity type buffer layer to form a second conductivity type emitter

FIG. 8

```
                                                                    ┌─ S401
┌─────────────────────────────────────────────────────────────────┐
│                                                                   │
│   forming an anode metal electrode under the second conductivity  │
│                          type emitter                             │
│                                                                   │
└─────────────────────────────────────────────────────────────────┘
                                │                           ┌─ S402
                                ▼
┌─────────────────────────────────────────────────────────────────┐
│                                                                   │
│   forming a cathode metal electrode on the first conductivity     │
│                         type emitter                              │
│                                                                   │
└─────────────────────────────────────────────────────────────────┘
                                │                           ┌─ S403
                                ▼
┌─────────────────────────────────────────────────────────────────┐
│   forming gate metal electrodes at positions on both sides of     │
│   the first conductivity type emitter and in contact with the     │
│   second conductivity type doped regions located in the second    │
│              conductivity type first base region                  │
└─────────────────────────────────────────────────────────────────┘
```

## FIG. 9

## INTERNATIONAL SEARCH REPORT

| International application No. |
|---|
| **PCT/CN2024/096808** |

### A. CLASSIFICATION OF SUBJECT MATTER

H01L29/74(2006.01)i; H01L29/744(2006.01)i; H01L29/06(2006.01)i; H01L29/10(2006.01)i; H01L21/332(2006.01)i

According to International Patent Classification (IPC) or to both national classification and IPC

### B. FIELDS SEARCHED

Minimum documentation searched (classification system followed by classification symbols)

IPC: H01L

Documentation searched other than minimum documentation to the extent that such documents are included in the fields searched

Electronic data base consulted during the international search (name of data base and, where practicable, search terms used)

CNTXT; ENTXT; ENTXTC; DWPI; CNKI; IEEE: 晶闸管, 基区, 发射极, 掺杂, 浓度, 电流密度, 关断, 载流子, 漂移, 电极, 缓冲, 扩散, 退火, thyristor, GCT, base, emitter, doping, concentration, current density, turn-off, carrier, drift, electrode, buffer, diffusion, anneal

### C. DOCUMENTS CONSIDERED TO BE RELEVANT

| Category* | Citation of document, with indication, where appropriate, of the relevant passages | Relevant to claim No. |
|---|---|---|
| PX | CN 116387358 A (TSINGHUA UNIVERSITY) 04 July 2023 (2023-07-04) entire document | 1-11 |
| A | CN 105590959 A (TSINGHUA UNIVERSITY) 18 May 2016 (2016-05-18) description, paragraphs 22-77, and figures 8-19 | 1-11 |
| A | US 2011057230 A1 (UDREA et al.) 10 March 2011 (2011-03-10) entire document | 1-11 |
| A | CN 111933704 A (ZHUZHOU CRRC TIMES SEMICONDUCTOR CO., LTD.) 13 November 2020 (2020-11-13) entire document | 1-11 |
| A | CN 109786451 A (QUANZHOU ZHENMEI INTELLIGENT TECHNOLOGY CO., LTD.) 21 May 2019 (2019-05-21) entire document | 1-11 |
| A | CN 109686783 A (TSINGHUA UNIVERSITY) 26 April 2019 (2019-04-26) entire document | 1-11 |

☐ Further documents are listed in the continuation of Box C.    ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **25 July 2024** | **01 August 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/096808**

| Patent document cited in search report | | | Publication date (day/month/year) | Patent family member(s) | | | Publication date (day/month/year) |
|---|---|---|---|---|---|---|---|
| CN | 116387358 | A | 04 July 2023 | CN | 116387358 | B | 01 August 2023 |
| CN | 105590959 | A | 18 May 2016 | None | | | |
| US | 2011057230 | A1 | 10 March 2011 | US | 8482031 | B2 | 09 July 2013 |
| CN | 111933704 | A | 13 November 2020 | None | | | |
| CN | 109786451 | A | 21 May 2019 | None | | | |
| CN | 109686783 | A | 26 April 2019 | None | | | |

Form PCT/ISA/210 (patent family annex) (July 2022)